# EUROPÄISCHE PATENTSCHRIFT

(11) **EP 0 349 732 B1**
(45) Veröffentlichungstag und Bekanntmachung des Hinweises auf die Patenterteilung: **27.04.1994**
(21) Anmeldenummer: 89108457.6
(22) Anmeldetag: 11.05.1989
(51) Int. Cl.: H03F 3/217

(54) **Leistungsverstärker**
Power amplifier
Amplificateur de puissance

(30) Priorität: 07.07.1988 DE 3822990
(43) Veröffentlichungstag der Anmeldung: 10.01.1990
(73) Patentinhaber: TELEFUNKEN Sendertechnik GmbH, 10553 Berlin (DE)
(72) Erfinder: Beeken, Horst, D-1000 Berlin 20 (DE); Weber, Klaus, Dipl.-Ing., D-1000 Berlin 65 (DE)
(74) Vertreter: Schulze, Harald Rudolf, Dipl.-Ing.

(56) Entgegenhaltungen:
- EP-A- 0 025 234
- EP-A- 0 058 443
- EP-A- 0 066 904
- EP-A- 0 261 366
- EP-A- 0 267 391
- DE-A- 3 447 566
- US-A- 4 403 197

## Beschreibung

Die Erfindung betrifft einen Leistungsverstärker gemäß dem Oberbegriff des Patentanspruchs 1.

Verstärker dieser Art werden allgemein zur Leistungsverstärkung analoger Eingangssignale insbesondere des Niederfrequenz- oder Tonfrequenzbereichs auf hohem Spannungsniveau eingesetzt und zeichnen sich insbesondere durch einen hohen Wirkungsgrad und eine hohe Wiedergabegüte, d.h. durch eine geringe Verzerrung des Verstärkerausgangssignals selbst im Bereich von Spannungen bis zu 30-50 kV aus. Bevorzugt werden sie als Modulationsverstärker für Sender und hier insbesondere für amplitudenmodulierte Hochleistungs-Rundfunksender des Lang-, Mittel- und Kurzwellenbereichs mit einer anodenmodulierten RF-Endstufenröhre eingesetzt, aber auch als Hochspannungs-Gleichstromversorgung insbesondere für die Stromversorgung von Magneten in Teilchenbeschleunigeranlagen eignen sie sich hervorragend. Andere Anwendungen wie z.B. Lautsprecheranlagen sind ebenfalls möglich.

Ein aus der EP-A1-0 025 234 bekannter Leistungsverstärker besteht aus N ausgangsseitig in Reihe geschalteten und primärseitig geschalteten Schaltverstärkern und einem nachgeschalteten Tiefpaßfilter. Die N Schaltverstärker sind zu N/2 Paare zusammengefaßt, die jeweils durch Zwei um 180° gegeneinander phasenverschobene pulsdauermodulierte Impulsfolgen angesteuert werden, während die Phasenverschiebung zwischen den einzelnen Impulsfolgepaaren 360°/N beträgt.

Die Paarbildung ist bei diesem bekannten Verstärker notwendig, da sonst die Ummagnetisierung der Trenntransformatoren in den einzelnen Schaltverstärkern, deren Einsatz zur galvanischen Trennung des Speisespannungseingangs des jeweiligen Schaltverstärkers von dessen Ausgang zwingend erforderlich ist, das Tastverhältnis der einzelnen Impulsfolgen, d.h. das Verhältnis der Impulsdauer zur Periodendauer der Schaltschwingung, auf etwa 0.5 oder 50 % Aussteuerung beschränken würde.

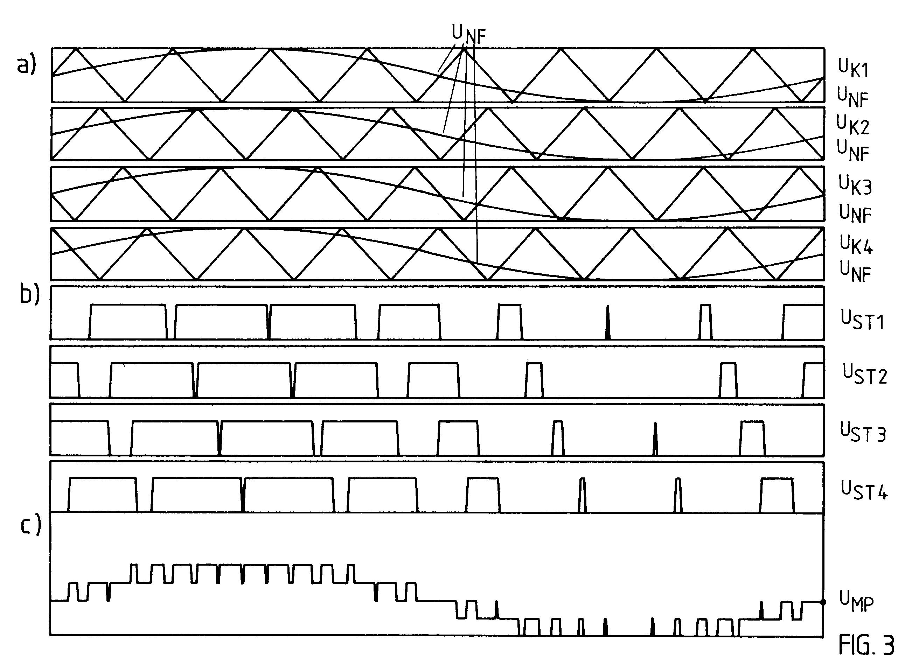

Das nachgeschaltete Tiefpaßfilter ist in seiner oberen Grenzfrequenz so dimensioniert, daß an seinem Ausgang das verstärkte und im wesentlichen unverzerrte Eingangssignal anliegt. Dabei ist der Filteraufwand bei einem solchen "mehrphasig" pulsdauermodulierten Verstärker wegen der damit verbundenen resultierenden höheren Abtastrate i.a. weitaus geringer als bei einem vergleichbaren herkömmlichen "einphasig" pulsdauermodulierten Verstärker (bei dem also die einzelnen Impulsfolgen nicht gegeneinander phasenverschoben sind), da das Summensignal der in Reihe geschalteten Schaltverstärker vor dem Tiefpaßfilter im ersten Fall bereits das verstärkte analoge Eingangssignal am Ausgang des Tiefpaßfilters in erster Näherung approximiert, d.h. vollständig enthält, jedoch mit Anteilen der Schaltschwingung überlagert ist (vgl. hierzu auch FIG. 3c).

Dem Vorteil eines verringerten Filteraufwands stehen bei dem bekannten Verstärker der Nachteil gegenüber, daß wegen der Paarbildung immer nur eine geradzahlige Anzahl von Schaltverstärkern verwendet werden kann. Darüber hinaus muß man bei der bekannten Lösung von einem erhöhten Aufwand bei den Transformatoren ausgehen, da neben den Trenntransformatoren i.a. auch noch ein vorgeschalteter Netztransformator für die Gleichspannungsversorgungen der einzelnen Schaltverstärker erforderlich ist.

Diese Nachteile können vermieden werden, wenn man, wie in der DE-OS-2 841 833 beschrieben ist, anstelle von in Reihe geschalteten Schaltverstärkern parallel geschaltete Schaltverstärker verwendet, da parallelgeschaltete Schaltverstärker keine galvanische Trennung von Speisespannungseingang und Verstärkerausgang erfordern und durch den damit verbundenen Wegfall der sonst erforderlichen Trenntransformatoren die einzelnen Schaltverstärker auch zu 100 % ausgesteuert werden können und ihre Zahl somit beliebig gewählt werden kann.

Diesen Vorteilen steht bei dieser bekannten Lösung der Nachteil gegenüber, daß mit der Parallelschaltung von Schaltverstärkern i. a. geringere Verstärkerausgangsspannungen technisch sinnvoll realisiert werden können als mit in Reihe geschalteten Schaltverstärkern.

Eine weitere Möglichkeit zur Umgehung der Trenntransformatoren ist aus der EP-A1-0 066 904 bekannt. Erreicht wird die diesbezügliche Lösung bei diesem Verstärker durch die Verwendung von sekundärseitig geschalteten Verstärkerstufen, die ausgangsseitig in Reihe geschaltet sind.

Die sekundärseitigen Schalter können, wenn sie mit pulsdauermodulierten Impulsen angesteuert werden, bei abnehmenden Tastverhältnis Unterstrichverzerrungen verursachen. Diese Unterstrichverzerrungen sind auf die Entladungsdauer der Schalterausgangskapazitäten zurückzuführen.

Während mit den bekannten Leistungsverstärkern mit entsprechend dimensionierten Tiefpaßfiltern eine nahezu verzerrungsfreie Verstärkung des analogen Eingangssignals durchaus realisierbar ist, wird der wegen des Einsatzes von Schaltverstärkern anstelle von Linearverstärkern theoretisch zu erwartende hohe Wirkungsgrad mit den bekannten Verstärkern in der Praxis keineswegs erreicht.

Eine wesentliche Ursache des in der Praxis überraschend geringen Wirkungsgrades der bekannten Leistungsverstärker ist die durch die hohe Abtast- bzw. Schaltfrequenz bedingte Verlustleistung in den Aufbaukapazitäten der in den Schaltverstärkern verwendeten Netztransformatoren.

Bei Transformatoren mit an Masse angeschlossener Schirmung sind es insbesondere die Schirmkapazitäten CT zwischen Schirmung und Sekundärwicklungen des Netztransformators (bei Netztransformatoren ohne Schirmung entsprechend die Wicklungskapazitäten zwischen Primär- und Sekundärwicklungen des Transformators), die für die hohe Verlustleistung in den Transformatoren verantwortlich sind. Aber auch die Querkapazitäten CQ zwischen räumlich benachbarten Sekundärwicklungen können erheblich zu diesen Verlusten beitragen.

In einer parallelen Anmeldung wurde deshalb vorgeschlagen, das Tiefpaßfilter so in die Schaltverstärker zu integrieren, d. h. komplette NF-Einzelverstärker zu bilden, daß diese an sich schädlichen Aufbaukapazitäten der Transformatoren, insbesondere die o. a. Schirmkapazitäten CT und/oder Querkapazitäten CQ Teile der einzelnen Tiefpaßfilter werden, so daß an den Transformatoren nicht mehr, wie bei den bekannten Leistungsverstärkern, die hohen Abtast- bzw. Schaltfrequenzen anliegen, sondern nur noch das abzutastende, niederfrequentere analoge Eingangssignal, was eine entsprechende Reduzierung der Verlustleistung in den Aufbaukapazitäten der Netztransformatoren zur Folge hat. Damit verbunden ist eine entsprechende Erhöhung des Wirkungsgrades des Leistungsverstärkers.

Die der Erfindung zugrunde liegende Aufgabe besteht darin, einen Leistungsverstärker zu schaffen, der bei hohem Wirkungsgrad und hoher Wiedergabegüte mit einem geringeren Transformatoraufwand auskommt, um eine Verstärkung des analogen Eingangssignales insbesondere auf hohem Spannungsniveau zu realisieren.

Die erfindungsgemäße Lösung dieser Aufgabe ist im Patentanspruch 1 beschrieben. Die übrigen Ansprüche enthalten vorteilhafte Aus- und Weiterbildungen der Erfindung sowie bevorzugte Anwendungen der Erfindung.

Bei der erfindungsgemäßen Schaltung werden u.a. als Schaltverstärker sekundärseitig geschaltete Schaltverstärker verwendet, da bei diesen Schaltverstärkern die galvanische Trennung des Schaltverstärkerausgangs von dem Speisespannungseingang, d. h. dem Netzanschluß bereits durch den Netztransformator erfolgt und der Einsatz spezieller Trenntransformatoren daher nicht erforderlich ist, so daß eine Beschränkung auf eine gerade Anzahl von Schaltverstärkern bei der erfindungsgemäßen Lösung entfällt und die einzelnen Schaltverstärker außerdem bis zu 100 % ausgesteuert werden können. Die Phasenverschiebung zwischen zwei zeitlich direkt aufeinanderfolgenden Impulsfolgen beträgt bei der erfindungsgemäßen Lösung vorteilhaft jeweils 360°/N, wobei N die Anzahl der verwendeten Schaltverstärker module ist.

Im folgenden wird die Erfindung anhand der Figuren näher erläutert. Es zeigen:
- FIG. 1: ein Blockschaltbild eines Leistungsverstärkers mit Steuerschaltung für die einzelnen Schaltverstärker
- FIG. 2: ein Blockschaltbild einer vorteilhaften Ausführungsform der Steuerschaltung des Leistungsverstärkers der FIG. 1
- FIG. 3: Typische Spannungs-Zeitverläufe des Leistungsverstärkers gemäß FIG. 1 mit einer Steuerschaltung gemäß FIG. 2
- FIG. 4-5: zwei bereits vorgeschlagene nicht erfindungsgemäße vorteilhafte Ausführungsformen eines sekundärseitig geschalteten Schaltverstärkers verwendbar in einem Leistungsverstärker gemäß FIG. 1
- FIG. 6: die Grundschaltung eines nicht erfindungsgemäßen Einzelverstärkermoduls, bestehend aus sekundärseitig geschaltetem Schaltverstärkerteil und integriertem Tiefpaßfilterteil, verwendbar in dem Leistungsverstärker gemäß FIG. 1
- FIG. 7: eine einphasig ausgebildete vorteilhafte Ausführungsform eines erfindungsgemäßen Einzelverstärkermoduls das eine Weiterbildung des Schaltverstärkermoduls nach Fig. 6 ist mit einstufigen Tiefpaßfiltern zur Verwendung in dem Leistungsverstärker gemäß FIG. 1
- FIG. 8: eine weitere, dreiphasig ausgebildete vorteilhafte Ausführungsform des erfindungsgemäßen Einzelverstärkermoduls gemäß FIG. 7 mit zweistufigen Tiefpaßfiltern zur Verwendung in dem Leistungsverstärker gemäß FIG. 1
- FIG. 9: ein detaillierter ausgeführtes erfindungsgemäßes Ausführungsbeispiel des Leistungsverstärkers gemäß FIG. 1 mit dreiphasig ausgeführten Verstärkermoduln gemäß FIG. 7
- FIG. 10: ein detaillierter ausgeführtes weiteres erfindungsgemäßes Ausführungsbeispiel des Leistungsverstärkers gemäß FIG. 1 mit Verstärkermoduln gemäß FIG. 8
- FIG. 11: eine Abwandlung des erfindungsgemäßen Leistungsverstärkers gemäß FIG. 9 mit einem zusätzlich nachgeschalteten Tiefpaßfilter
- FIG. 12: ein Detail einer bereits vorgeschlagenen vorteilhaften Ausführungsform eines Drehstrom-Netztransformators mit sekundärseitigen Herausführungen zum Anschluß zweier Schaltverstärker über einen gemeinsamen Stützer
- FIG.13-14: einen bereits vorgeschlagenen Stützer gemäß FIG. 12 in der Seitenansicht (FIG. 13) und Draufsicht (FIG. 14).

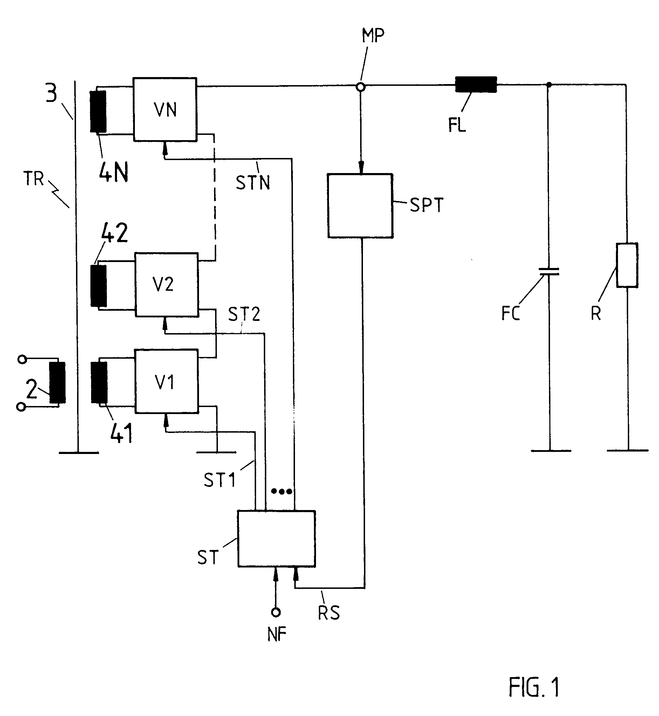

Der Leistungsverstärker in FIG. 1 besteht aus N vorzugsweise gleichartigen sekundärseitig geschalteten Schaltverstärkern V1-VN, die ausgangsseitig in Reihe geschaltet sind und denen ein Tiefpaßfilter FL und FC nachgeschaltet ist, das in seiner oberen Grenzfrequenz so dimensioniert ist, daß am Verstärkerausgang das verstärkte und im wesentlichen unverzerrte Eingangssignal anliegt. Die Last ist der Einfachheit halber beispielhaft durch einen ohmschen Widerstand R dargestellt.

Zur Stromversorgung ist ein (beispielhaft einphasig ausgeführter) Netztransformator TR vorgesehen, der eine an ein (nicht gezeigtes) Versorgungsnetz angeschlossene Primärwicklung 2 und eine der Anzahl der Schaltverstärker V1-VN entsprechenden Zahl von Sekundärwicklungen 41-4N aufweist, wobei die Schaltverstärker V1-VN mit ihren Speisespannungseingängen an die entsprechenden Sekundärwicklungen 41-4N des Netztransformators TR angeschlossen sind. Der Transformator TR ist zusätzlich mit einer an Masse liegenden Schirmung 3 versehen, über die die kapazitiven Ströme, die durch das zu übertragende HF-Signal hervorgerufen werden, und, bei der nicht erfindungsgemäßen Verwendung von Schaltverstärkern ohne integrierte Tiefpaßfilter, die zusätzlichen kapazitiven Ströme, die durch das sekundärseitige Schalten der Gleichspannungen hervorgerufen werden,nach Masse abgeleitet werden können.

Die Schaltverstärker V1-VN sind mit ihren Steuereingängen über separate Steuerleitungen ST1-STN mit einer gemeinsamen Steuerschaltung ST verbunden, die beispielsweise als digitale Rechnerschaltung oder in Analogtechnik realisiert sein kann.

Am Ausgang der in Reihe geschalteten Schaltverstärker ist ein Meßpunkt MP vorgesehen, an dem die Ausgangsspannung des Schaltverstärkerteils abgegriffen und uber einen Spannungsteiler SPT als Rückkopplungssignal RS der Steuerschaltung ST zugeführt ist.

In der Steuerschaltung ST werden in Abhängigkeit von dem eingangsseitig anliegenden und durch das Rückkopplungssignal korrigierten Eingangssignal NF pulsdauermodulierte Impulsfolgen zur Ansteuerung der einzelnen Schaltverstärker V1-VN erzeugt und über die einzelnen Steuerleitungen ST1-STN an die zugeordneten Schaltverstärkerstufen V1-VN übertragen.

Zur Erhöhung der resultierenden Abtastfrequenz bzw. zur Verringerung des Aufwands beim nachgeschalteten Tiefpaßfilter sind die einzelnen Impulsfolgen gegeneinander phasenverschoben, wobei die Phasenverschiebung zwischen zwei zeitlich aufeinanderfolgenden Impulsfolgen vorteilhafterweise 360°/N beträgt.

Zur galvanischen Trennung der Steuerschaltung ST von den Schaltverstärkern V1-VN sind die einzelnen Steuerleitungen ST1-STN vorteilhafterweise zumindest abschnittsweise in Form von Lichtleitkabeln realisiert.

Die pulsdauermodulierten und ebenfalls um 360°/N gegeneinander phasenverschobenen Schaltimpulsfolgen an den Ausgängen der einzelnen Schaltverstärker werden aufgrund der Reihenschaltung aufsummiert, wobei das Summationssignal in erster Näherung bereits das verstärkte Eingangssignal approximiert, wie dies in FIG. 3c anhand eines Summationssignals U_{MP} gezeigt ist, das beispielhaft aus vier jeweils um 90° gegeneinander phasenverschobenen Schaltimpulsfolgen U_{ST1}-U_{ST4} gebildet ist, deren Schaltimpulsdauern jeweils proportional zu den entsprechenden Amplitudenwerten eines beispielhaft sinusförmigen Eingangssignals U_{NF} sind.

In dem nachgeschalteten Tiefpaßfilter FL, FC wird das Summationssignal U_{MP} einer weiteren Glättung unterzogen, d.h. es werden die verbleibenden Anteile der Schaltschwingung und ihrer Oberschwingungen gesperrt (in der Praxis stark gedämpft), so daß am Ausgang des Filters das verstärkte Eingangssignal im wesentlichen unverzerrt anliegt.

Durch die Rückkopplung eines Teils des Summationssignals in den Eingangskreis des Verstärkers werden (statische oder dynamische) Ungleichheiten in den einzelnen Schaltverstärkerstufen V1-VN kompensiert, die ohne diese Kompensation das Ausgangssignal zusätzlich verzerren würden, was bei der Verwendung des erfindungsgemäßen Leistungsverstärkers als Modulationsverstärker in einem Sender im Frequenzspektrum entweder als diskrete Spektrallinien erscheinen würde oder in Form von Rauschen den eigenen Nachrichtenkanal bzw. in Form überhöhter Randaussendungen wodurch die Nachbarkanäle stören würde.

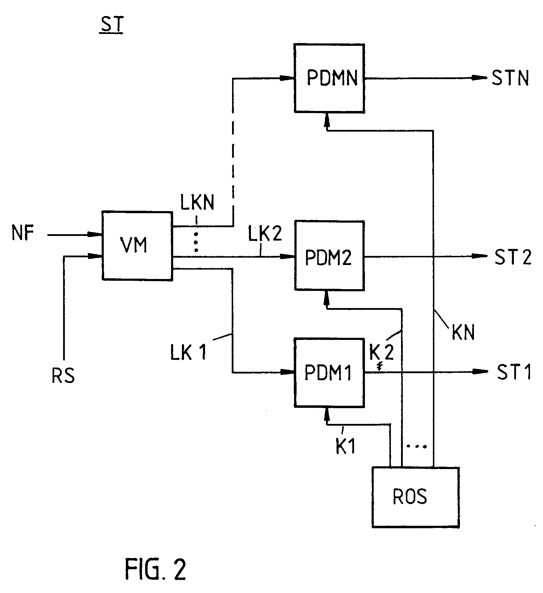

In FIG. 2 ist eine vorteilhafte Ausführungsform der Steuerschaltung ST des Leistungsverstärkers gemäß FIG. 1 gezeigt.

Bei dieser Schaltung ist jedem der Schaltverstärker V1-VN jeweils ein separater Pulsdauermodulator PDM1-PDMN zugeordnet, der in digitaler oder analoger Technik aufgebaut sein kann und der die zur Ansteuerung des ihm zugeordneten Schaltverstärkers V1-VN erforderlichen Impulsfolge erzeugt und diese über die zugehörige Steuerleitung ST1-STN dem Schaltverstärker V1-VN zuleitet.

Die einzelnen Pulsdauermodulatoren PDM1-PDMN sind mit ihren Referenzeingängen über separate zweite Übertragungsleitungen K1-KN mit einer gemeinsamen Referenzoszillatorstufe ROS verbunden, die die zur Bildung der pulsdauermodulierten Impulsfolgen erforderliche Referenz- oder Schaltschwingung mit der für den jeweiligen Schaltverstärker V1-VN geforderten Phasenbeziehung erzeugt. Eigangsseitig sind die Pulsdauermodulatoren PDM1-PDM4 über separate erste Übertragungsleitungen LK1-LKN mit einer gemeinsamen Modulatorvorstufe VM verbunden, die das zu verstärkende Eingangssignal NF für die Pulsdauermodulatoren PDM1-PDMN aufbereitet.

Zur galvanischen Trennung sind vorzugsweise entweder die Steuerleitungen ST1-STN oder alternativ hierzu sowohl die ersten als auch die zweiten Übertragungsleitungen LK1-LKN bzw. K1-KN vorteilhaft zumindest abschnittsweise mit Lichtleitkabeln realisiert.

FIG. 3 zeigt anhand eines Beispiels von vier in Reihe geschalteten Schaltverstärkern V1-V4 mit einer analog ausgeführten Steuerschaltung gemäß FIG. 2 typische Spannungs-Zeitverläufe einzelner Signale.

In FIG. 3a ist die beispielhaft sinusförmige Eingangs-Signalspannung U_{NF} gezeigt, die in den vier Pulsdauermodulatoren PDM1-PDM2 mit beispielhaft dreieckförmigen Referenz- oder Schaltspannungen U_{K1}-U_{KN} verglichen wird, wobei die einzelnen Referenzspannungen U_{K1}-U_{KN} jeweils um 90° gegeneinander phasenverschoben sind.

In den Zeiten, in denen die Eingangssignalspannung U_{NF} größer oder gleich der jeweiligen Referenzspannungen U_{K1}-U_{KN} ist, erzeugt der entsprechende Pulsdauermodulator jeweils einen positiven Ausgangsimpuls. Die so entstehenden Ausgangsimpulsfolgen U_{ST1}-U_{ST4} sind in FIG. 3b gezeigt. Sie dienen der Ansteuerung der entsprechenden Schaltverstärker V1-V4, an deren Ausgängen synchron mit den Steuerimpulsfolgen U_{ST1}-U_{ST4} Schaltimpulsfolgen entstehen, die zu einem Summationssignal U_{MP} auf summiert werden, wie FIG. 3c zeigt.

In einer vorteilhaften digitalen Ausbildung der Steuerschaltung ST wird der Vergleich des Eingangssignals NF mit einem Referenzsignal nach einer eingangsseitigen Digitalisierung durchgeführt, indem die in FIG. 3 dreieckförmig gewählten Referenzspannungen U_{K1}-U_{KN} durch synchron geschaltete Zähler ersetzt werden und der Vergleich des Eingangssignals auf digitalem Wege erfolgt. Dabei können die Zähler z.B. als diskrete integrierte Schaltungen oder vorzugsweise mit Hilfe eines Signalprozessors realisiert werden, wobei die Vielzahl der Zähler durch einen entsprechenden Algorithmus realisiert werden.

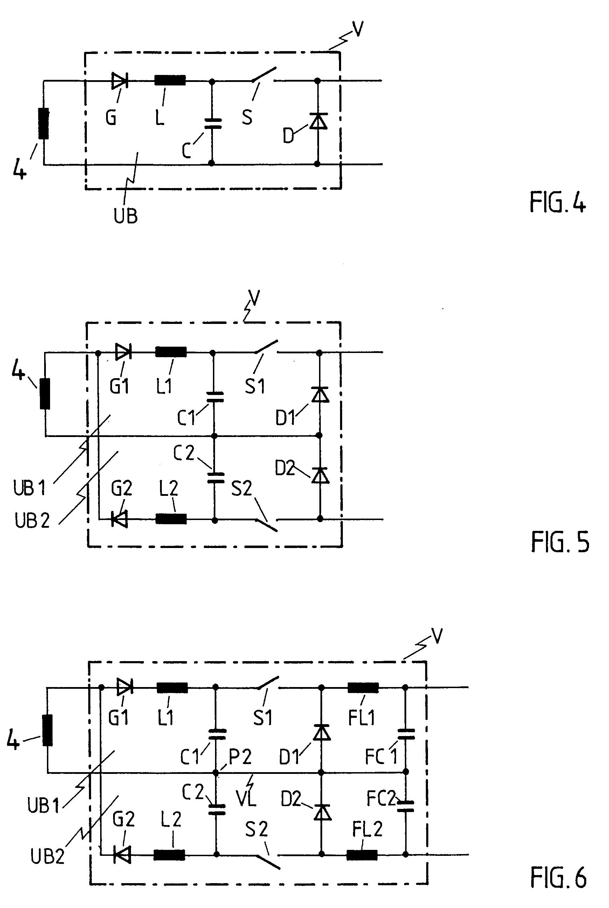

In den Figuren 4-5 sind zwei bereits vorgeschlagene nicht erfindungsgemäße Ausführungsformen von sekundärseitig geschalteten Schaltverstärkern V gezeigt, die beispielhaft einphasig ausgeführt sind und die auch vorteilhaft in dem Leistungsverstärker gemäß FIG. 1 eingesetzt werden können.

Die aus der DE-A1-30 44 956 bekannten Grundschaltung in FIG. 4 besteht aus einer Gleichrichterdiode G, einer Siebdrossel L, einem Siebkondensator C, die zusammen mit einem Netztransformator, von dem nur die Sekundärwicklung 4 gezeigt ist, ein Gleichspannungsnetzgerät UB bilden, das durch einen Schalter S ein- und ausgeschaltet werden kann und das im ausgeschalteten Zustand von einer Freilaufdiode D überbrückt wird. Der Schalter S wird dabei von der in der (nicht gezeigten) Steuerschaltung (ST in FIG. 1 oder 2) erzeugten Impulsfolge angesteuert.

Die aus der EP-A1-0 066 904 bekannten Schaltung gemäß FIG. 5 besteht aus einem Doppelnetzgerät, das sich aus zwei in Reihe geschalteten und an eine gemeinsame Sekundärwicklung 4 angeschlossenen Gleichspannungsnetzgeräten UB1 und UB2 zusammensetzt und das über die Schalter S1 und S2 ein- und ausgeschaltet werden kann und im ausgeschalteten Zustand von den beiden in Reihe geschalteten Freilaufdioden D1 und D2 überbrückt wird. Dabei sind die Schalter S1 und S2 unabhängig voneinander ansteuerbar, so daß das eine Gleichspannungsnetzgerät UB1 unabhängig von dem anderen Gleichspannungsnetzgerät UB2 ein- und ausschaltbar ist. Die Schalter S1 uns S2 können somit entweder mit der gleichen Impulsfolge angesteuert werden oder alternativ hierzu durch zwei gegeneinander phasenverschobene Impulsfolgen.

In FIG. 6 ist die Grundschaltung eines nicht erfindungsgemäßen Einzelverstärkermoduls gezeigt, der sich zur Verwendung in dem Leistungsverstärkers gemäß FIG. 1 eignet. Die Schaltung besteht aus einem kompletten NF-Verstärkermodul V, das aus einem sekundärseitig geschalteten und im Aufbau mit der Schaltung gemäß FIG. 5 identischen Schaltverstärker und aus einem "integrierten" Tiefpaßfilter FL1, FC1, FL2, FC2 besteht. Der Vorteil dieser Schaltung besteht vor allem darin, daß durch die durchgehende Verbindungsleitung VL störende Aufbaukapazitäten des Netztransformators wie z.B. die Querkapazitäten benachbarter Sekundärwicklungen oder die Schirmkapazitäten zwischen Schirmung und Sekundärwicklungen (oder die Wicklungskapazitäten zwischen Primär- und Sekundärwicklungen, die insbesondere bei Transformatoren ohne Schirmung besonders ausgeprägt sind) in das Tiefpaßfilter integriert werden, so daß am Netztransformator nicht mehr die Schaltfrequenz, sondern nur noch das niederfrequentere Eingangssignal NF anliegt, was zu einer erheblichen Verminderung der Verluste führt, da diese Aufbaukapazitäten nicht mehr mit der Schaltfrequenz umgeladen werden müssen.

Während bei Verwendung von Schaltverstärkern z.B. gemäß FIG. 4 oder 5 ohne integrierte Tiefpaßfilter die Reihenschaltung der Schaltverstärker durch die Reihenschaltung der Freilaufdioden erfolgt, wird bei Verwendung von Einzelverstärkern z.B. gemäß FIG. 6 mit integriertem Tiefpaßfilter die Reihenschaltung der Schaltverstärker durch die Reihenschaltung der Filterkondensatoren realisiert.

Ein weiterer Vorteil der Schaltungen gemäß FIG. 5 und 6 besteht darin, daß durch die Verwendung von Doppelnetzgeräten die Zahl der erforderlichen Sekundärwicklungen gegenüber der Schaltung gemäß FIG. 4 um die Hälfte auf N/2 reduziert wird.

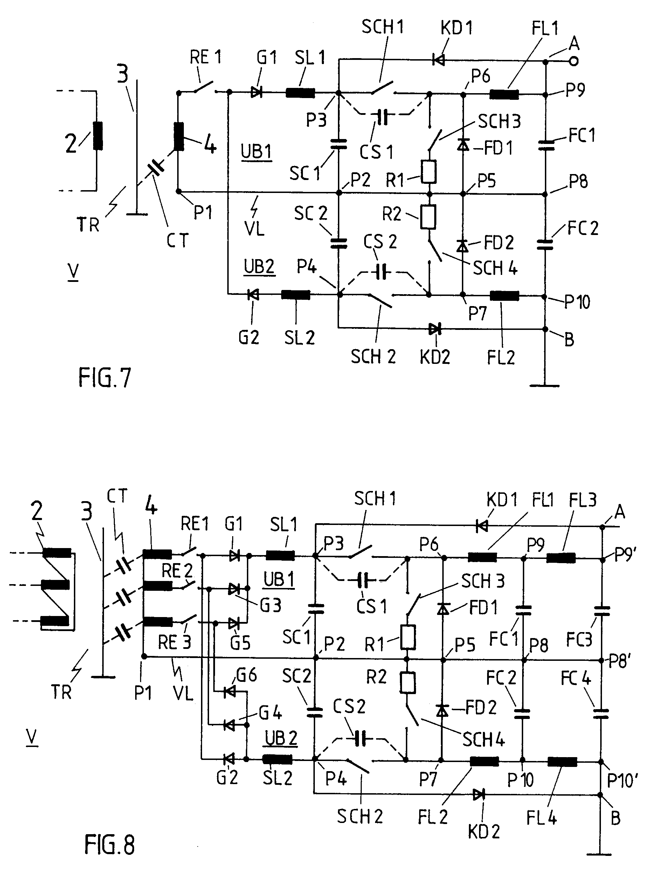

Das aus der Grundschaltung gemäß FIG. 6 weiterentwickelte erfindungsgemäße Verstärkermodul V in FIG. 7 zur Verwendung in dem Leistungsverstärker in FIG. 1 besteht aus zwei Einzelverstärkern, die jeweils aus einem aus Gleichspannungsnetzgerät UB1 bzw. UB2, Schalter SCH1 bzw. SCH2 und Freilaufdiode FD1 bzw. FD2 aufgebauten sekundärseitig geschalteten Schaltverstärker sowie aus einem aus Filterspule FL1 bzw. FL2 und Filterkondensator FC1 bzw. FC2 aufgebauten Tiefpaßfilter bestehen.

Erfindungsgemäß sind in diesem Verstärkermodul V sowohl die Gleichspannungsnetzgeräte UB1 und UB2 und die Freilaufdioden FD1 und FD2 der beiden Schaltverstärker als auch die Filterkondensatoren FC1 und FC2 der beiden Tiefpaßfilter jeweils in Reihe geschaltet und die Verbindungspunkte P2, P5 und P8 zwischen den jeweiligen Bauelemente-Paaren dieser drei Reihenschaltungen über eine durchgehende Verbindungsleitung VL miteinander verbunden. Die äußeren Endpunkte P3, P6, P9 bzw. P4, P7, P10 dieser drei Reihenschaltungen sind jeweils über eine weitere Reihenschaltung aus Schalter SCH1 bzw. SCH2 und Filterspule FL1 bzw. FL2 miteinander verbunden, wobei die Reihenschaltung der Freilaufdioden FD1 und FD2 mit ihren beiden Endpunkten P6 bzw. P7 jeweils zwischen Schalter SCH1 bzw. SCH2 und Filterspule FL1 bzw. FL2 angeschlossen ist.

Die Reihenschaltung der beiden Gleichspannungsnetzgeräte UB1 und UB2 ist in diesem Verstärkermodul V in Form eines an sich bekannten und beispielsweise im TELEFUNKEN Röhrentaschenbuch, Ausgabe 1956, auf Seite 310 beschriebenen Doppelnetzgeräts realisiert.

Dieses Doppelnetzgerät enthält einen Netztransformator TR, der in dem Ausführungsbeispiel in FIG. 7 beispielhaft einphasig mit einer Primärwicklung 2 und einer Sekundärwicklung 4 ausgeführt ist und der zur Ableitung kapazitiver Schaltströme eine an Masse angeschlossene Schirmung 3 enthält.

In dieser wie auch in den folgenden Figuren sind der Übersichtlichkeit wegen keine weiteren Details im Aufbau des verwendeten Transformators (Eisenkern, Isoliermaterialien usw.) enthalten, die aber dennoch bei der konkreten Realisierung sehr wohl zu berücksichtigen sind.

An das eine Ende der Sekundärwicklung sind zwei gegenpolig parallel ("antiparallel") geschaltete Gleichrichter G1 und G2 angeschlossen, die bezüglich des anderen Endes P1 der Sekundärwicklung zwei Roh-Gleichspannungen mit unterschiedlicher Polarität erzeugen, die in dem jeweils nachgeschalteten LC-Siebglied, bestehend aus Siebdrossel SL1 bzw. SL2 und Siebkondensator SC1 bzw. SC2, gesiebt, d.h. geglättet werden. Die Siebkondensatoren SC1 und SC2 sind bei diesem Doppelnetzgerät in Reihe geschaltet, wobei ihr gemeinsamer Verbindungspunkt P2 über die durchgehende Verbindungsleitung VL mit dem anderen Ende P1 der Sekundärwicklung 4 verbunden ist.

Die an dem jeweiligen Siebkondensator SC1 bzw. SC2 anliegende geglättete Gleichspannung stellt dabei die Ausgangsspannung des jeweiligen Gleichspannungsnetzgerätes UB1 bzw. UB2 dar.

Mit dem symmetrischen Aufbau des erfindungsgemäßen Verstärkermoduls V mit der durchgehenden Verbindungsleitung VL als "Symmetrieachse" ist im erfindungsgemäßem Verstärkermodul V eine durchgehende symmetrische Verbindung vorhanden zwischen der Sekundärwicklung 4 des Netztransformators (TR) einerseits und den Filterkondensatoren FC1 bzw. FC2 der Tiefpaßfilter andererseits, wodurch insbesondere die sekundärwicklungsbedingten Aufbaukapazitäten des Netztransformators TR direkt mit den Tiefpaßfiltern verbunden und in diese "integriert" sind.

Die Schirmkapazität CT zwischen der Sekundärwicklung 4 und der an Masse liegenden Schirmung 3 beispielsweise, die neben den weiter unten diskutierten Querkapazitäten CQ zwischen räumlich benachbarten Sekundärwicklungen einen wesentlichen Teil dieser schädlichen Aufbaukapazitäten darstellt und die in der FIG. 7 gestrichelt eingezeichnet ist, ist in einem vereinfachten Ersatzschaltbild mit einem Ende an Masse und (wegen der direkten Verbindung der Punkte P1 und P2 in FIG. 7) mit dem anderen Ende an den Verbindungspunkt P2 der beiden in Reihe geschalteten Gleichspannungsnetzgeräte UB1 und UB2 angeschlossen.

Äquivalent hierzu ist wegen der direkten symmetrischen Verbindung VL der Verbindungspunkte P2 und P8 ein anderes Ersatzschaltbild der FIG. 7, in dem die Schirmkapazität CT parallel zum Filterkondensator FC2 geschaltet ist und damit einen integralen Bestandteil des entsprechenden Tiefpaßfilters FL2, FC2 bildet.

Der große Vorteil dieser erfindungsgemäßen Schaltung besteht darin, daß mit dieser Integration insbesondere der sekundärwicklungsbedingten Aufbaukapazitäten des Netztransformators in die Tiefpaßfilter an dem Transformator nicht mehr, wie bei den bekannten Leistungsverstärkern, die hohen Abtast- bzw. Schaltfrequenzen anliegen, sondern nur noch das abzutastende niederfrequentere Eingangssignal, so daß die schädlichen Aufbaukapazitäten nur noch mit der Frequenz des Eingangssignals (und nicht mehr mit der Schaltfrequenz) umgeladen werden, was mit einer entsprechenden Reduzierung der Verlustleistung in den Aufbaukapazitäten des Netztransformators bzw. mit einer entsprechenden Verbesserung des Wirkungsgrades des Leistungsverstärkers verbunden ist.

Ein qualitativer Vergleich des erfindungsgemäßen Leistungsverstärkers mit einem beispielsweise aus der DE-A1-36 35 365 oder der EP-A1-0 066 904 bekannten Leistungsverstärkers mag diesen Sachverhalt verdeutlichen.

Der bekannte Schaltverstärker verwendet ebenfalls das an sich bekannte Doppelnetzgerät, um damit aber zwei in Reihe geschaltete Schaltverstärker UB1, SCH1, FD1 bzw. UB2, SCH2, FD2 zu realisieren, denen ein gemeinsames Tiefpaßfilter FL, FC nachgeschaltet ist.

Da bei dieser Schaltung die durchgehende symmetrische Verbindung zwischen Sekundärwicklung des Netztransformators und dem Tiefpaßfilter fehlt, liegt in dem Fall, gemäß einem bei synchron angesteuerten Schaltern SCH1 und SCH2 hierzu äquivalenten Ersatzschaltbild mit einem Netzgerät UB (der doppelten Ausgangsspannung), einem Schalter SCH und einer Freilaufdiode FD, die schädliche Schirmkapazität CT nicht mehr parallel zum Filterkondensator FL, sondern parallel zur Freilaufdiode FD und wird daher im Takt der weitaus höheren Schaltfrequenz umgeladen, was mit einer entsprechenden Verschlechterung des Wirkungsgrades des Leistungsverstärkers einhergeht.

In FIG. 8 ist ein weiteres besonders vorteilhaftes Ausführungsbeispiel des erfindungsgemäßen Verstärkermoduls V gezeigt, das sich von der in FIG. 7 gezeigten Schaltung dadurch unterscheidet,
- daß anstelle des einphasig ausgeführten Netztransformators hier ein primärseitig im Dreieck und sekundärseitig im Stern P1 geschalteter Drehstrom-Netztransformator vorgesehen ist, dem sekundärseitig zwei gegenpolig parallel geschaltete Drehstrom-Stern-Gleichrichterschaltungen G1, G3, G5 bzw. G2, G4, G6 nachgeschaltet sind und bei dem der Verbindungspunkt P2 der in Reihe geschalteten Siebkondensatoren SC1 und SC2 mit dem Sternpunkt P1 der Sekundärwicklungen 4 direkt verbunden ist und
- daß anstelle der einstufig ausgeführten Tiefpaßfilter hier beispielhaft zweistufig ausgeführte Tiefpaßfilter FL1, FC1; FL3, FC3 bzw. FL2, FC2; FL4, FC4 vorgesehen sind, die für eine noch stärkere Dämpfung der Schaltfrequenz und ihrer Oberschwingungen, d.h. für eine noch geringere Verzerrung der Verstärkerausgangsspannung sorgen.

In einem entsprechenden Ersatzschaltbild dieser Schaltung wären die Schirmkapazitäten CT zwischen den einzelnen Sekundärwicklungen 4 und der Schirmung 3 in FIG. 8 parallel zu dem Filterkondensator FC4 der zweiten Filterstufe FL4, FC4 des unteren Tiefpaßfilters geschaltet und zu einer gemeinsamen Schirmkapazität zusammengefaßt.

Die Schalter SCH1 bzw. SCH2 des erfindungsgemäßen Verstärkermoduls V in den FIG. 7 oder 8 können unabhängig voneinander angesteuert, d.h. ein- und ausgeschaltet werden. Die von dem Eingangssignal abgeleiteten Impulsfolgen legen dabei die zeitliche Abfolge der Schaltimpulse fest. Die resultierende Ausgangsspannung U_{A} am Ausgang des Verstärkermoduls V kann im Idealfall in Abhängigkeit von diesen Impulsfolgen bzw. den Schaltimpulsen statisch oder dynamisch jeden beliebigen Wert zwischen 0 Volt (beide Schalter ausgeschaltet) und 2U_{B} (beide Schalter eingeschaltet) annehmen, wobei U_{B} die Ausgangsspannung eines Gleichspannungsnetzgerätes UB1 oder UB2 ist.

Vorteilhafterweise werden die beiden Schalter SCH1 bzw. SCH2 des erfindungsgemäßen Verstärkermoduls V jedoch synchron, d.h. zeitgleich mit pulsdauermodulierten Impulsfolgen angesteuert, da in diesem Fall die Schaltung in FIG. 8 wie eine Drehstrom-Brückenschaltung wirkt, die es erlaubt, die an sich schädlichen Aufbaukapazitäten des Netztransformators durch Integration in die Tiefpaßfilter unschädlich zu machen und die gleichzeitig den guten Wirkungsgrad einer Drehstrom-Brückenschaltung aufweist.

Bei konstantem Lastwiderstand R ändern sich bei Ansteuerung des erfindungsgemäßen Verstärkermoduls V mit pulsdauermodulierten Impulsfolgen theoretisch die Ausgangsspannung U_{A} und der Ausgangsstrom linear mit dem Tastverhältniswert V_{T}, d.h. mit dem Verhältnis zwischen der Einschaltzeit T_{EIN} der synchron angesteuerten Schalter SCH1 und SCH2 und der Periodendauer T der Schaltschwingung. In der Praxis gilt dieser lineare Zusammenhang jedoch nicht. Die tatsächliche Ausgangsspannung U_{A} weicht mit abnehmenden Tastverhältniswert V_{T} zunehmend von dem theoretischen Wert ab, so daß sich im Bereich kleiner Eingangssignalamplituden bzw. schmaler Schaltimpulse in der Ausgangsspannung U_{A} sogenannte "Unterstrichverzerrungen ergeben.

Diese Unterstrichverzerrungen entstehen durch die Auf- und Entladung unerwünschter Schaltkapazitäten CS an der mit Schaltimpulsen beaufschlagten Seite der Filterspulen FL1 und FL2. Diese Schaltkapazitäten sind im wesentlichen die Ausgangskapazitäten CS1 und CS2 der verwendeten Schalter SCH1 und SCH2, die im Prinzip parallel zu den zugehörigen Schalter geschaltet sind.

Da jedoch die Kapazität der beiden Siebkondensatoren SC1 bzw. SC2 sehr groß ist und diese somit für die Schaltschwingung einen Kurzschluß darstellen, liegen die Ausgangskapazitäten CS1 bzw. CS2 der beiden Schalter SCH1 bzw. SCH2 in Wirklichkeit parallel zu der jeweiligen Freilaufdiode FD1 bzw. FD2.

Diese Kapazitäten CS1 bzw. CS2 werden beim Schließen der Schalter SCH1 bzw. SCH2 auf U_{B} aufgeladen und nach dem Öffnen der Schalter durch den durch die Filterspulen FL1 bzw. FL2 fließenden Strom entladen. Erst nach vollständiger Entladung der "Kondensatoren" CS1 und CS2 fließt der Strom in gewünschter Weise durch die Freilaufdioden FD1 und FD2. Die Entladezeit ist dabei umgekehrt proportional zum Strom, so daß sich dieser störende Effekt vor allem bei kleinen Stromwerten in Form der oben beschriebenen Unterstrichverzerrungen bemerkbar macht.

Zur Reduzierung dieser Unterstrichverzerrungen sind in der bisher diskutierten Grundschaltung des erfindungsgemäßen Verstärkermoduls V in den Schaltungen der FIG. 7 und 8 den beiden Freilaufdioden FD1 und FD2 jeweils eine Reihenschaltung aus Widerstand R1 bzw. R2 und weiterem Schalter SCH3 bzw. SCH4 parallel geschaltet, die im Gegentakt zu den beiden ,"Hauptschaltern" SCH1 und SCH2 arbeiten und die für die Entladung der Schaltkapazitäten CS1 und CS2 sorgen.

Vorteilhafterweise ist zwischen Öffnen (Schließen) der Hauptschalter SCH1 und SCH2 und Schließen (Öffnen) der "Entladeschalter" SCH3 und SCH4 jeweils eine Verzögerungs-bzw. Totzeit vorgesehen, deren Dauer vorzugsweise in etwa den Entladezeiten der Schaltkapazitäten CS1 und CS2 für große Stromwerte, d.h. bei Oberstrich und Strich entspricht, so daß bei Oberstrich und Strich die Umladeleistung über den Lastwiderstand R abfließt und nur bei Unterstrich in den Entladewiderständen R1 und R2 verbraucht wird.

Da in dieser Zeit aber nur geringe Entladeströme fließen, wird der Wirkungsgrad des Verstärkermoduls durch diese Maßnahme nur unerheblich verschlechtert bei gleichzeitig erheblichen Verbesserungen der Qualitätswerte des Ausgangssignals (geringerer Verzerrungsgrad). Zur Optimierung ist es vorteilhaft, die Verzögerungszeit zwischen Öffnen (Schließen) der Hauptschalter SCH1 bzw. SCH2 und Schließen (Öffnen) der Entladeschalter SCH3 und SCH4 in Abhängigkeit von den Stromwerten variabel zu machen, so daß als Entladeschalter Schalter kleinerer Schaltleistung (und i.a. entsprechend kürzeren Schaltzeiten) eingesetzt werden können.

Zur Realisierung der Schalter ist in Abhängigkeit von der zu schaltenden Spannung bzw. dem zu schaltenden Strom entweder ein einzelner Schalter oder mehrere in Reihe und/oder parallel geschaltete Schalter vorzusehen.

Als Schalter werden vorzugsweise Halbleiterschalter eingesetzt. Von den derzeit verfügbaren Bauelementen kommen dafür in Frage MOS-Feldeffekttransistoren (MOSFET), Static-Induction-Transistoren (SIT), Static-Induction-Thyristoren (SITh), Abschaltthyristoren (GTO), Kaskade- oder Kaskode-Schaltungen usw.

Aus dieser Reihe von Bauelemente-Arten ist jedoch der MOSFET z.Z. am günstigsten, da sich mit ihm sehr kurze Schaltzeiten (und damit sehr geringe Schaltverluste) erzielen lassen. Außerdem entfallen bei ihm die für die bipolaren Bauelemente typischen Speicherzeiten. Ferner ist die Parallelschaltung mehrer MOSFETs unproblematisch, da sie im Gegensatz zu Bipolartransistoren einen negativen Temperaturgradienten aufweisen, der dazu führt, daß der Durchlaßwiderstand eines MOSFETs mit steigender Temperatur zunimmt und der Durchlaßstrom entsprechend abnimmt, so daß sich der zu führende Gesamtstrom automatisch gleichmäßig auf die parallel geschalteten MOSFETs aufgeteilt und eine überlastung einzelner MOSFET dadurch verhindert wird.

Um bei Lastabwurf, d.h. bei Unterbrechung der Verbindung zum Lastwiderstand, die nunmehr ungedämpften Tiefpaßfilter in dem erfindungsgemäßen Verstärkermodul V an dem Punkt A in den FIG. 7 und 8 nicht auf die doppelte Ausgangsspannung 2U_{A} schwingen zu lassen, ist in einer weiteren vorteilhaften Weiterbildung der erfindungsgemäßen Grundschaltung jeweils eine Kappdiode KD1 bzw. KD2 vom Verstärkerausgang A bzw. B zum Ausgang P3 bzw. P4 des zugeordneten Gleichspannungsnetzgeräts UB1 bzw. UB2 geschaltet, die diese Überschwinger in den Spannungen "klemmt", d.h. abschneidet. Die Dioden KD1, KD2 brauchen nicht sehr schnell zu sein, d.h. tᵣᵣ kann groß sein. Sie müssen nur die Schwingungen bei der Resonanzfrequenz der Tiefpaßfilter (die im Anwendungsfall als Modulationsverstärker für einen Sender im kHz-Bereich liegt) kappen können.

Zur Abschaltung des gesamten Verstärkermoduls V z.B. in Störfällen kann in einer vorteilhaften Weiterbildung der erfindungsgemäßen Grundschaltung gemäß den Schaltungen in FIG. 7 und 8 der Netztransformator TR durch Leistungs-Schutzrelais RE1-RE3 von der übrigen Schaltung getrennt werden.

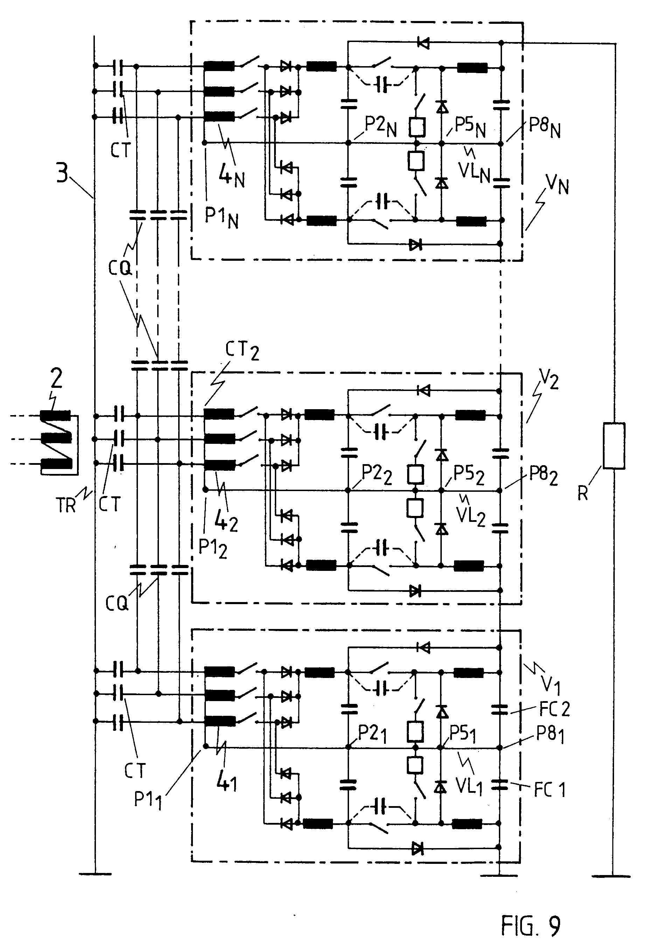

Zur Realisierung des Leistungsverstärkers gemäß FIG. 1 werden mehrere dieser erfindungsgemäßen Verstärkermoduln V, die ja in sich bereits komplette Leistungsverstärker sind, ausgangsseitig in Reihe schaltet, wie dies anhand der Figuren 9-11 im folgenden näher erläutert werden soll.

Der Leistungsverstärker in FIG. 9 besteht aus N gleichartigen erfindungsgemäßen Verstärkermoduln V₁-V_{N} gemäß FIG. 7 in dreiphasiger Ausführung, wobei die Netztransformatoren der einzelnen Verstärkermoduln V₁-V_{N} vorteilhafterweise zu einem Netztransformator TR mit einem Satz von im Dreieck geschalteten Primärwicklungen 2 und mit einer der Zahl der Verstärkermoduln V₁-V_{N} entsprechenden Anzahl von Sekundärwicklungssätzen 4₁-4_{N} sowie mit einer an Masse liegenden gemeinsamen Schirmung 3 zusammengefaßt worden sind.

Ein Vorteil dieser Lösung gegenüber der aus der DE-A1-30 44 956 bekannten Lösung (vgl. FIG. 4) besteht darin, daß die Zahl der sekundären Transformatorwicklungen durch die Verwendung von Doppelnetzgeräten halbiert ist, so daß schon allein deswegen die Verlustleistungen in den Aufbaukapazitäten des Netztransformators in der Regel geringer ausfallen.

Leistungsreduzierungen des erfindungsgemäßen Verstärkers erfolgen entweder durch zwangsweises Abschalten einzelner Verstärkermoduln durch die Schalter in den Verstärkermoduln selbst oder vorteilhaft durch die jeweils zwischen Transformator TR und Gleichrichterschaltungen (G1-G6 in FIG. 8) angebrachten Leistungs-Schutzrelais (RE1-RE3 in FIG. 8), da im letzterem Fall auch bei durchlegierten (leitenden) Halbleiterschaltern die betreffenden Moduln abgeschaltet werden können.

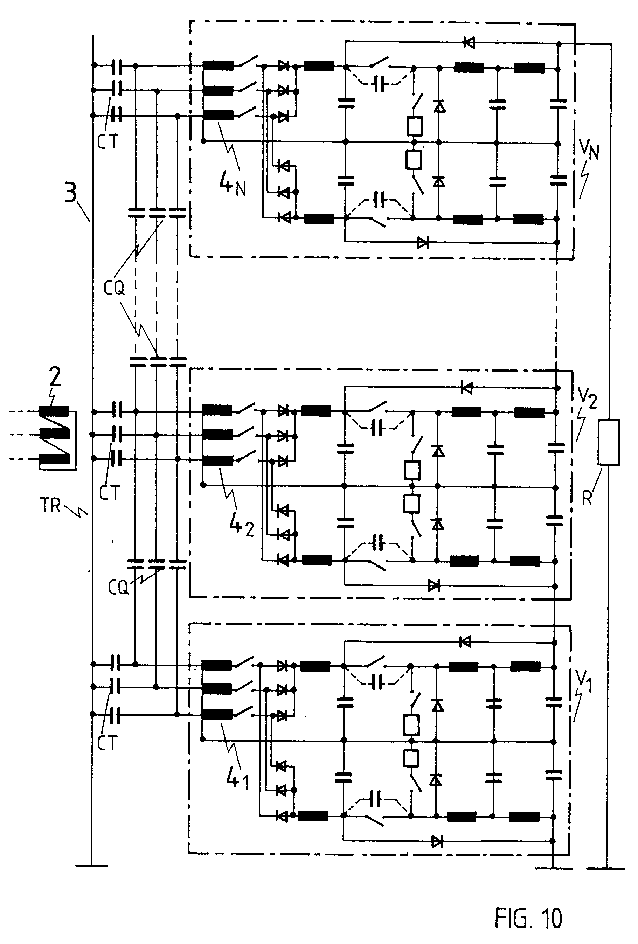

Der Leistungsverstärker in FIG. 10 unterscheidet sich von dem Verstärker in FIG. 9 dadurch, daß die einzelnen Tiefpaßfilter in den Verstärkermoduln V₁-V_{N} gemäß FIG. 8 zweistufig ausgeführt worden sind.

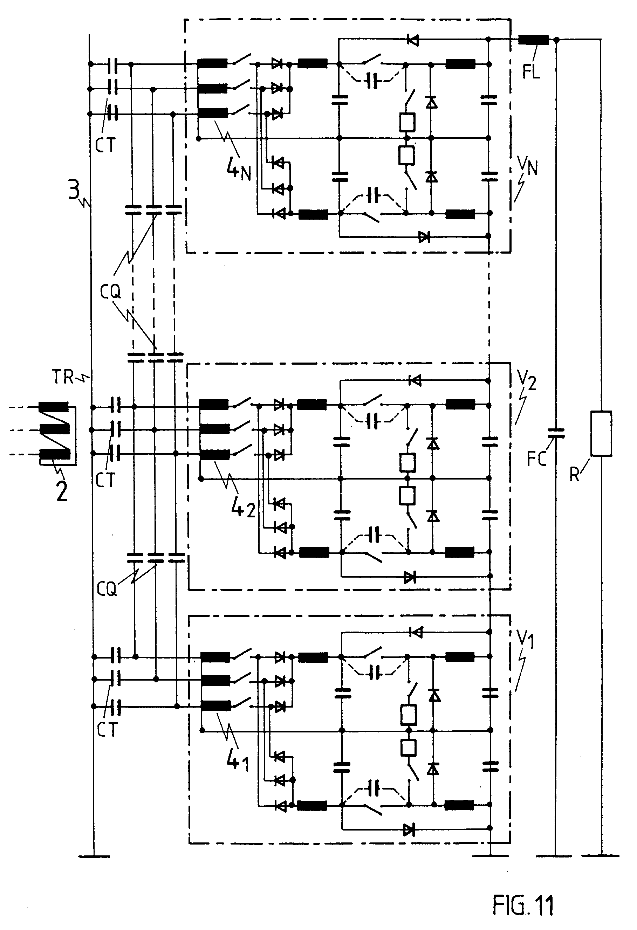

Der Leistungsverstärker in FIG. 11 unterscheidet sich von dem Verstärker in FIG. 9 dadurch, daß ein separates Tiefpaßfilter FL, FC dem Leistungsverstärker nachgeschaltet ist.

In den Figuren 9-11 sind die entsprechenden neben Schirmkapazitäten CT zusätzlich auch die weiter oben bereits erwähnten Querkapazitäten CQ zwischen räumlich benachbarten Sekundärwicklungen 4₁-4_{N} des Netztransformators TR eingezeichnet. Die Schimkapazitäten CT bzw. Ouerkapazitäten CQ sind dabei der Übersichtlichkeit wegen als echte Kondensatoren (mit durchgezogenen Verbindungslinien) und nicht als aufbaubedingte Kapazitäten (mit gestrichelten Verbindungslinien) gezeichnet. Hiermit soll jedoch nur verdeutlicht werden, daß diese Kapazitäten integrale Bestandteile der nachgeschalteten Tiefpaßfilter in den einzelnen Verstärkermoduln V₁-V_{N} sind. Aus Gründen der Übersichtlichkeit sind außerdem in diesen Figuren keine weiteren Details zum Aufbau des verwendeten Netztransformators (Eisenkern, Isoliermaterialien usw.) enthalten, die aber dennoch bei der Realisierung der erfindungsgemäßen Leistungsverstärker zu berücksichtigen sind.

Bei bestimmten Anwendungen kann es vorteilhaft sein, anstelle des bisher diskutierten einstufigen Tiefpaßfilters ein mehrstufiges Tiefpaßfilter, z.B. ein zweistufiges Tiefpaßfilter, zu verwenden. Hier gibt es zwei Möglichkeiten, das Filter erfindungsgemäß zu integrieren. Entweder wird es, wie z.B. in FIG. 10 gezeigt, voll in die einzelnen Verstärkermoduln V₁-V_{N} integriert, wobei in diesem Fall nur die Filterkondensatoren der jeweils letzten Filterstufe der einzelnen Tiefpaßfilter in Reihe zu schalten wären, oder es wird, wie z.B. in FIG. 11 gezeigt, nur ein Teil der Filterstufen integriert und die restlichen Stufen dem Leistungsverstärker nachgeschaltet.

Der Vorteil der ersten Lösung (FIG. 10) ist vor allem in der vollen Prüfbarkeit der einzelnen Verstärkermoduln zu sehen, während die zweite Lösung (FIG. 11) vor allem den Vorteil hat, daß sich fertigungstechnische Toleranzen der einzelnen Filterglieder der ersten Stufe praktisch nicht auf die Qualitätswerte des Ausgangssignals des Leistungsverstärkers auswirken können.

Mit der erfindungsgemäßen Lösung ist es generell möglich, mit einer relativ niedrigen Schaltfrequenz für die einzelnen Schaltverstärker und der Phasenverschiebung eine relativ hohe resultierende Abtast- bzw. Schaltfrequenz insgesamt zu erreichen, die mit der Anzahl der in Reihe geschalteten Schaltverstärker linear anwächst und die u.a. einen erheblichen verringerten Filteraufwand zur Folge hat. Eine erhebliche Verringerung des Aufwands bei den Transformatoren wird, wie weiter oben bereits erwähnt, erfindungsgemäß durch die Verwendung von sekundärseitig geschalteten Schaltverstärkern erzielt.

Es versteht sich, daß die Erfindung mit fachmännischem Können und Wissen aus- und weitergebildet werden kann bzw. an die unterschiedlichen Anwendungen angepaßt werden kann, ohne daß dies hier an dieser Stelle näher erläutert werden muß.

So ist es z.B. möglich, in den Figuren 9 bis 11 anstelle des einen Drehstromtransformators mit einem z.B. im Dreieck geschalteten Primärwicklungssatz und N Sekundärwicklungssätzen zwei Drehstromtransformatoren mit jeweils N/2 Sekundärwicklungssätzen zu verwenden, von denen der eine primärseitig im Dreieck und der andere pirmärseitig im Stern geschaltet ist, so daß fiktiv dadurch eine 12-Pulsschaltung mit entsprechend verringertem Netzoberschwingungsanteil realisiert wird.

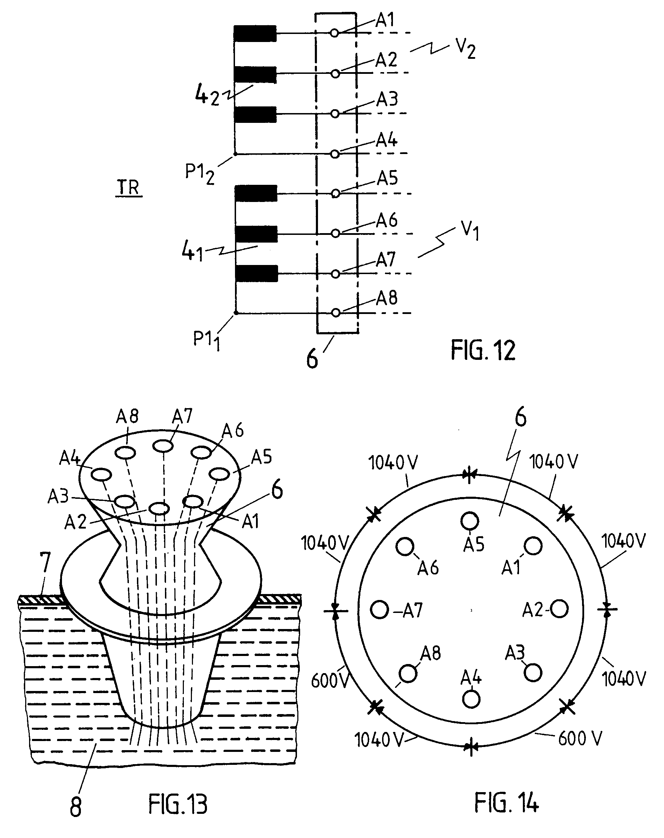

Weiterhin ist es von der Konstruktion eines Netztransformators her von Vorteil, gemäß FIG. 12 die sekundärseiten Anschlüsse A1-A4 bzw. A5-A8 zweier räumlich benachbarter und im Stern geschalteter Sekundärwicklungssätze 4₁ und 4₂ eines Drehstrom-Netztransformators TR über einen gemeinsamen Stützer 6 aus dem Tranformatorgehäuse herauszuführen.

Gemäß FIG. 13 ist ein solcher Stützer 6 z.B. aus Gießharz herstellbar und in die Außenwand 7 eines mit Öl 8 gefüllten Netztransformators einsetzbar. Die Anschlüsse A1 bis A8 entsprechend dabei denjenigen der FIG. 12.

FIG. 14 zeigt eine Aufsicht auf einen Stützer gemäß FIG. 13. Die an dem Außenring angegebenen Spannungsangaben sind beispielhaft gewählte Effektivwerte für Gleichspannungsnetzgeräte (UB1, UB2 in FIG. 8), die jeweils Gleichspannungen von ungefähr ± 670 V bezüglich des Verbindungspunktes P2 in FIG. 7 oder 8 erzeugen.

Ferner ist es möglich, zur galvanischen Trennung Impulsübertrager anstelle von Lichtleitkabeln in den Steuer- und/oder Übertragungsleitungen der Steuerschaltung vorzusehen.

Außerdem ist es möglich, das Rückkopplungssignal nicht vor dem nachgeschalteten Tiefpaßfilter zu gewinnen, sondern am Ausgang des Tiefpaßfilters, was insbesondere dann von Vorteil ist, wenn das Tiefpaßfilter ganz oder teilweise in die einzelnen Schaltverstärker integriert ist.

Schließlich ist es möglich, die komplette Ansteuerung der Schaltstufen mit einem Mikrocomputer oder Mikroprozessor zu realisieren.

## Patentansprüche

1. Leistungsverstärker zum Verstärken eines analogen Eingangssignales (NF), mit N ausgangsseitig in Reihe geschalteten Schaltverstärkermodulen (V) und einem ausgangsseitigen Tiefpaßfilter, wobei die Schalter (SCH1; SCH2) der Verstärkermodule (V) durch Signale einer Steuerschaltung (ST) angesteuert werden, welche aus dem Eingangssignal (NF) abgeleitet sind, wobei als Schaltverstärker in den Verstärkermodulen (V) sekundärseitig geschaltete Schaltverstärker vorgesehen sind, wobei jeweils zwei direkt hintereinander in Reihe geschaltete und jeweils aus Gleichspannungsnetzgerät (UB1; UB2), Schalter (SCH1; SCH2) und Freilaufdiode (FD1; FD2) bestehende Schaltverstärker zu einem Verstärkermodul (V) derart zusammengefaßt sind, daß die Gleichspannungsnetzgeräte (UB1; UB2) und die Freilaufdioden (FD1, FD2) der beiden Schaltverstärker jeweils miteinander in Reihe geschaltet sind, dadurch gekennzeichnet, daß die Schaltverstärker durch pulsdauermodulierte Impulsfolgen angesteuert sind, die gegeneinander phasenverschoben sind, daß zwischen den beiden in Reihe geschalteten Gleichspannungsnetzgeräten (UB1, UB2) und den beiden in Reihe geschalteten Freilaufdioden (FD1, FD2) in dem Verstärkermodul (V) jeweils eine Reihenschaltung aus einem weiteren Schalter (SCH3; SCH4) und einem Widerstand (R1; R2) parallel zu der jeweiligen Freilaufdiode (FD1; FD2) geschaltet ist, daß diese beiden weiteren Schalter (SCH3, SCH4) jeweils komplementär, d. h. im Gegentakt zu dem zugehörigen ersten Schalter (SCH1; SCH2) geschaltet sind, daß das Tiefpaßfilter (FL1, FC1; FL2, FC2) ganz oder teilweise in die einzelnen Schalterverstärkermodule (V1-VN) integriert ist und daß die beiden Filterkondensatoren (FC1, FC2) eines Schaltverstärkermodules miteinander in Reihe geschaltet sind.

2. Leistungsverstärker nach Anspruch 1, dadurch gekennzeichnet, daß die Phasenverschiebung zwischen zwei zeitlich direkt aufeinander folgenden Impulsfolgen jeweils 360°/N beträgt.

3. Leistungsverstärker nach einem der Ansprüche 1 bis 2, dadurch gekennzeichnet, daß die Steuerschaltung (ST) über vorzugsweise als Lichtleitkabel ausgebildete Steuerleitungen (ST1-STN) mit den einzelnen Schaltverstärkern (V1-VN) verbunden ist.

4. Leistungsverstärker nach Anspruch 3,
dadurch gekennzeichnet,
- daß zur Erzeugung der einzelnen Impulsfolgen in der Steuerschaltung (ST) digital oder analog arbeitende Pulsdauermodulatoren (PDM1-PDMN) vorgesehen sind;
- daß jeder dieser Pulsdauermodulatoren (PDM1-PDMN) ausgangsseitig über eine der vorzugsweise als Lichtleitkabel ausgebildeten Steuerleitungen (ST1-STN) mit dem ihm zugeordneten Schaltverstärker (V1-VN) und eingangsseitig über eine erste Übertragungsleitung (LK1-LKN) mit einer für alle Pulsdauermodulatoren (PDM1-PDMN) gemeinsamen Modulatorvorstufe (VM) verbunden ist;
- daß jeder dieser Pulsdauermodulatoren (PDM1-PDMN) mit seinem Referenzeingang über eine zweite Übertragungsleitung (K1-KN) mit einer für alle Pulsdauermodulatoren (PDM1-PDMN) gemeinsamen Referenzoszillatorstufe (ROS) verbunden ist und von dieser ein mit der Phasenverschiebung der von ihm zu erzeugenden Impulsfolge versehenes Referenzsignal empfängt.

5. Leistungsverstärker nach einem der Ansprüche 3 bis 4, dadurch gekennzeichnet, daß ein Teil des vor oder nach dem Tiefpaßfilter (FL, FC) anliegenden Verstärkerausgangssignals über einen Spannungsteiler (SPT) als Rückkopplungssignal (RS) der Steuerschaltung (ST) bzw. der Modulatorvorstufe (VM) zugeführt ist.

6. Leistungsverstärker nach einem der Ansprüche 1 bis 5, dadurch gekennzeichnet,
- daß die Schaltverstärker (V1-VN) mit Netztransformatoren ausgerüstet sind ;
- daß diese Netztransformatoren zu einem Netztransformator (TR) mit einer Primärwicklung (2) und einer der Anzahl der Schaltverstärker module (V1-VN) entsprechenden Zahl von Sekundärwicklungen (41-4N) zusammengefaßt sind;
- daß bei Verwendung von Netztransformatoren mit Schirmung auch die Schirmungen zu einer gemeinsamen an Masse liegenden Schirmung (3) zusammengefaßt sind ;
- daß für den Fall eines Drehstrom-Netztransformators mit der dreifachen Zahl von Primärwicklungen die Primärwicklungen im Dreieck geschaltet sind.

7. Leistungsverstärker nach einem der Ansprüche 1 bis 5, dadurch gekennzeichnet,
- daß die Schaltverstärker mit Netztransformatoren ausgerüstet sind;
- daß diese Netztransformatoren zu zwei Netztransformatoren mit jeweils einer Primärwicklung und einer der halben Anzahl der Schaltverstärker module entsprechenden Zahl von Sekundärwicklungen zusammengefaßt sind;
- daß die beiden Netztransformatoren vorzugsweise jeweils eine an Masse liegende Schirmung aufweisen;
- daß für den Fall von Drehstrom-Netztransformatoren mit der dreifachen Zahl von Primärwicklungen die Primärwicklungen des einen Transformators im Dreieck und die Primärwicklungen des anderen Transformators im Stern geschaltet sind.

8. Leistungsverstärker nach einen der Ansprüche 1 bis 7, dadurch gekennzeichnet,
- daß die Netztransformatoren der beiden Schaltverstärker zu einem für beide Gleichspannungsnetzgeräte (UB1, UB2) gemeinsamen, vorzugsweise dreiphasig ausgeführten Netztransformator (TR) mit in einem Sternpunkt (P1) zusammengeschalteten Sekundärwicklungen (4) zusammengefaßt sind;
- daß die Verbindungspunkte (P2, P5, P8) zwischen den in Reihe geschalteten Gleichspannungsnetzgeräten (UB1, UB2), den in Reihe geschalteten Freilaufdioden (FD1, FD2) und den in Reihe geschalteten Filterkondensatoren (FC1, FC2) über eine durchgehende Verbindungsleitung (VL) direkt mit dem Sternpunkt (P1) verbunden sind;
- daß die Endpunkte (P3, P6, P9; P4, P7, P10) der drei Reihenschaltungen aus Gleichspannungsnetzgeräten (UB1, UB2), Freilaufdioden (FD1, FD2) und Filterkondensatoren (FC1, FC2) jeweils über eine weitere Reihenschaltung aus Schalter (SCH1; SCH2) und Filterspule (FL1; FL2) miteinander verbunden sind und die Reihenschaltung der Freilaufdioden (FD1, FD2) mit ihren Endpunkten (P6; P7) dabei jeweils zwischen Schalter (SCH1; SCH2) und Filterspule (FL1; FL2) angeschlossen ist.

9. Leistungsverstärker nach Anspruch 8, dadurch gekennzeichnet,
- daß die beiden Tiefpaßfilter in dem Verstärkermodul (V) jeweils aus mehreren hintereinander geschalteten Filterstufen (FL1, FC1; FL3, FC3 bzw. FL2, FC2; FL4, FC4) bestehen;
- daß die einzelnen Filterstufen jeweils eine Filterspule (FL1-FL4) und einen der jeweiligen Filterspule nachgeschalteten Filterkondensator (FC1-FC4) enthalten;
- daß die Filterspulen (FL1, FL3 bzw. FL2, FL4) der einzelnen Filterstufen eines Tiefpaßfilters jeweils in Reihe und die Filterkondensatoren (FC1, FC3 bzw. FC2, FC4) der Filterstufen eines Tiefpaßfilters jeweils parallel zueinander geschaltet sind;
- daß die Filterkondensatoren (FC1, FC2 bzw. FC3, FC4) gleichrangiger Filterstufen (FL1, FC1; FL2, FC2 bzw. FL3, FC3; FL4, FC4) der beiden Tiefpaßfilter jeweils in Reihe geschaltet sind und
- daß die Verbindungspunkte (P8, P8') zwischen zwei jeweils in Reihe geschalteten Filterkondensatoren (FC1, FC2 bzw. FC3, FC4) über die durchgehende Verbindungsleitung (VL) direkt mit dem Sternpunkt (P1) verbunden sind.

10. Leistungsverstärker nach einem der Ansprüche 8 bis 9, dadurch gekennzeichnet,
- daß die beiden in Reihe geschalteten Gleichspannungsnetzgeräte (UB1, UB2) in dem Verstärkermodul (V) durch zwei gegenpolig parallel an die dem Sternpunkt (P1) gegenüberliegenden Enden der Sekundärwicklungen (4) des Netztransformators (TR) angeschlossene und bezüglich des Sternpunktes (P1) zwei Gleichspannungen mit unterschiedlicher Polarität erzeugende Drehstrom-SternGleichrichterschaltungen (G1, G3, G5 bzw. G2, G4, G6) mit jeweils einem nachgeschalteten und aus Siebdrossel (SL1 bzw. SL2) und Siebkondensator (SC1 bzw. SC2) bestehenden Siebglied (SL1, SC1 bzw. SL2, SC2) realisiert sind;
- daß die Siebkondensatoren (SC1, SC2) der beiden Siebglieder (SL1; SC1 bzw. SL2, SC2) in Reihe geschaltet sind und ihr gemeinsamer Verbindungspunkt der über die durchgehende Verbindungsleitung (VL) direkt an den Sternpunkt (P1) angeschlossene Verbindungspunkt (P2) der beiden in Reihe geschalteten Gleichspannungsnetzgeräte (UB1, UB2) ist.

11. Leistungsverstärker nach einem der Ansprüche 8 bis 10, dadurch gekennzeichnet, daß jeder der beiden Endpunkte (P3; P4) der Gleichspannungsnetzgeräte-Reihenschaltung (UB1, UB2) jeweils über eine Kappdiode (KD1; KD2) mit dem ihm zugeordneten Ausgang (A; B) des Verstärkermoduls (V) verbunden ist.

12. Leistungsverstärker nach einem der Ansprüche 8 bis 11, dadurch gekennzeichnet, daß dem Netztransformator (TR) sekundärseitig Leistungs-Schutzrelais (RE1-RE3) nachgeschaltet sind.

13. Leistungsverstärker nach einem der Ansprüche 8 bis 12, dadurch gekennzeichnet, daß die einzelnen Verstärkermoduln (V₁-V_{N}) gleich aufgebaut sind und im wesentlichen gleiche Ausgangssignale liefern.

14. Leistungsverstärker nach einem der Ansprüche 8 bis 13, dadurch gekennzeichnet, daß die Schalter (SCH1-SCH4) in den einzelnen Verstärkermoduln (V) jeweils aus einem Halbleiterschalter oder mehreren in Reihe und/oder parallel geschalteten Halbleiterschaltern bestehen.

15. Leistungsverstärker nach Anspruch 14, dadurch gekennzeichnet, daß die Halbleiterschalter MOS-Feldeffekttransistoren (MOSFET) oder Static-Induction-Transistoren (SIT) oder Static-Induction-Thyristoren (SITh) oder Abschaltthyristoren (GTO) oder Kaskade- oder Kaskode-Schaltungen sind.

16. Leistungsverstärker nach einem der Ansprüche 8 bis 15, dadurch gekennzeichnet, daß den ausgangsseitig in Reihe geschalteten Verstärkermoduln (V₁-V_{N}) ein zusätzliches Tiefpaßfilter (FL, FC) nachgeschaltet ist.

17. Leistungsverstärker nach einem der Ansprüche 1 bis 16, gekennzeichnet durch die Anwendung als Modulationsverstärker für Sender, insbesondere als Modulationsverstärker für amplitudenmodulierte Hochleistungs-Rundfunksender des Lang-, Mittel- und Kurzwellenbereichs mit einer anodenmodulierten RF-Endstufenröhre.

18. Leistungsverstärker nach einem der Ansprüche 1 bis 16, gekennzeichnet durch die Anwendung als Hochspannungs-Gleichstromversorgung, insbesondere für die Stromversorgung von Magneten in Teilchenbeschleunigeranlagen.

## Claims

1. Power amplifier, for amplifying an analog input signal (NF), with N switching amplifier modules (V) connected in series at the output and a low-pass filter at the output, wherein the switches (SCH1; SCH2) of the amplifier modules (V) are selectably driven by signals of a control circuit (ST), which are derived from the input signal (NF), wherein switching amplifiers switched at the secondary side in the amplifier modules (V) are provided as switching amplifiers, wherein two switching amplifiers, which are connected in series one directly behind the other and each consist of a direct voltage mains unit (UB1; UB2), the switches (SCH1; SCH2) and a freewheel diode (FD1; FD2), are each time combined into an amplifier module (V) in such a manner that the direct voltage mains units (UB1; UB2) and the freewheel diodes (FD1; FD2) of both the switching amplifiers are each time connected one in series with the other, characterised thereby, that the switching amplifiers are selectably driven by pulse sequences, which are modulated in pulse duration and displaced in phase one relative to the other, that a respective series connection of a further switch (SCH3; SCH4) and a resistor (R1; R2) is connected in parallel with the respective freewheel diode (FD1; FD2) in the amplifier module (V) between both the direct voltage mains unit (UB1; UB2) connected in series and both the freewheel diodes (FD1; FD2) connected in series, that both these further switches (SCH3; SCH4) are each time connected complementarily, i.e. in opposite phase to the associated first switch (SCH1; SCH2), that the low-pass filter (FL1, FC1; FL2, FC2) is entirely or partially integrated into the individual switching amplifier modules (V1 to VN) and that both the filter capacitors (FC1, FC2) of a switching amplifier module are connected one in series with the other.

2. Power amplifier according to claim 1, characterised thereby, that the phase displacement between two pulse sequences following one directly upon the other in time amounts to 360°/N each time.

3. Power amplifier according to one of the claims 1 and 2, characterised thereby, that the control circuit (ST) is connected with the individual switching amplifier modules (V1 to VN) by way of control lines (ST1 to STN) preferably constructed as optical conductor cables.

4. Power amplifier according to claim 3, characterised thereby,
- that pulse duration modulators (PDM1 to PDMN) operating digitally or in analog are provided for the production of the individual pulse sequences in the control circuit (ST),
- that each of these pulse duration modulators (PDM1 to PDMN) is connected at the output with the respectively associated switching amplifier (V1 to VN) by way of one of the control lines (ST1 to STN) preferably constructed as optical conductor cables and at the input with a modulator input stage (VM), which is common to all pulse duration modulators (PDM1 to PDMN), by way of a first transmission line (LK1 to LKN) and
- that each of these pulse duration modulators (PDM1 to PDMN) is connected by its reference input with a reference oscillator stage (ROS), which is common to all pulse duration modulators (PDM1 to PDMN), by way of a second transmission line (K1 to KN) and receives a reference signal therefrom provided with the phase displacement of the pulse sequence to be produced by it.

5. Power amplifier according to one of the claims 3 and 4, characterised thereby, that a part of the amplifier output signal, which is present before or behind the low-pass filter (FL, FC), is fed as feedback signal (RS) by way of a voltage divider (SPT) to either the control circuit (ST) or to the modulator input stage (VM).

6. Power amplifier according to one of the claims 1 to 5, characterised thereby,
- that the switching amplifiers (V1 to VN) are equipped with mains transformers,
- that these mains transformers are combined into a mains transformer (TR) with one primary winding (2) and a number of secondary windings (41 to 4N) corresponding to the number of the switching amplifier modules (V1 to VN),
- that in the case of mains transformers with screening, the screens are also combined into a common screen (3) connected to ground and
- that the primary windings are connected in delta for the case of a polyphase mains transformer with three times the number of primary windings.

7. Power amplifier according to one of the claims 1 to 5, characterised thereby,
- that the switching amplifiers are equipped with mains transformers,
- that these mains transformers are combined into two mains transformers each with a respective primary winding and a number of secondary windings corresponding to half the number of the switching amplifier modules,
- that both the mains transformers each preferably display a respective screen connected to ground, and
- that the primary windings of the one transformer are connected in delta and the primary windings of the other transformer are connected in star for the case of polyphase mains transformers with three times the number of primary windings.

8. Power amplifier according to one of the claims 1 to 7, characterised thereby,
- that the mains transformers of both the switching amplifiers are combined into one mains transformer (TR), which is common to both the direct voltage mains units (UB1; UB2) and preferably in three-phase construction with secondary windings (4) connected together in a star point (P1),
- that the junctions (P2, P5, P8) between the direct voltage mains units (UB1; UB2) connected in series, the freewheel diodes (FD1, RD2) connected in series and the filter capacitors (FC1, FC2) connected in series are connected directly with the star point (P1) by way of a continuous connecting line (VL) and
- that the end points (P3, P6, P9; P4, P7, P10) of the three series connections of the direct voltage mains units (UB1; UB2), the freewheel diodes (FD1, FD2) and the filter capacitors (FC1, FC2) are each time connected by way of a further series connection of a switch (SCH1; SCH2) and a filter coil (FL1; FL2) and the series connection of the freewheel diodes (FD1, FD2) is in that case connected by its end points each time between the switch (SCH1; SCH2) and the filter coil (FL1; FL2).

9. Power amplifier according to claim 8, characterised thereby,
- that both the low-pass filters in the amplifier module (V) each consist of several filter stages (FL1, FC1; FL3, FC3 or FL2, FC2; FL4, FC4) connected one behind the other,
- that the individual filter stages each contain a respective filter coil (FL1 to FL4) and a filter capacitor (FC1 to FC4) respectively connected behind the respective filter coil,
- that the filter coils (FL1, FL3 or FL2, FL4) of the individual filter stages of a low-pass filter are each time connected in series and the filter capacitors (FC1, FC3 or FC2, FC4) of the filter stages of a low-pass filter are each time connected in parallel one to the other,
- that the filter capacitors (FC1, FC2 or FC3, FC4) of filter stages (FL1, FC1; FL2, FC2 or FL3, FC3; FL4, FC4) of equal rank of both the low-pass filters are each time connected in series and
- that the junctions (P8, P8') between each two filter capacitors (FC1, FC2 or FC3, FC4) respectively connected in series are connected directly with the star point (P1) by way of the continuous connecting line (VL).

10. Power amplifier according to one of the claims 8 and 9, characterised thereby,
- that both the direct voltage mains units (UB1; UB2) connected in series in the amplifier module (V) are realised by two polyphase rectifier star circuits (G1, G3, G5 or G2, G4, G6), which are connected with opposite polarity parallelly to those ends of the secondary windings (4) of the mains transformer (TR), which lie opposite the star point (P1), and which produce two direct voltages of opposite polarity with respect to the star point (P1), each with a respective filter member (SL1, SC1 or SL2, SC2), which is connected therebehind and consists of a filter choke (SL1 or SL2) and a filter capacitor (SC1 or SC2), and
- that the filter capacitors (SC1, SC2) of both the filter members (SL1, SC1 or SL2, SC2) are connected in series and their common junction is the junction (P2), which is directly connected to the star point (P1) by way of the continuous connecting line (VL), of both the direct voltage mains units (UB1; UB2) connected in series.

11. Power amplifier according to one of the claims 8 to 10, characterised thereby, that each of both the end points (P3; P4) of the series connection of the direct voltage mains units (UB1; UB2) is connected by way of a respective clamping diode (KD1; KD2) with the respectively associated output (A; B) of the amplifier module (V).

12. Power amplifier according to one of the claims 8 to 11, characterised thereby, that the power protection relays (RE1 to RE3) are connected behind the mains transformer (TR) at the secondary side.

13. Power amplifier according to one of the claims 8 to 12, characterised thereby, that the individual amplifier modules (V1 to VN) are constructed identically and deliver substantially equal output signals.

14. Power amplifier according to one of the claims 8 to 13, characterised thereby, that the switches (SCH1; SCH2) in the individual amplifier modules (V) each consist of a semiconductor switch or of several semiconductor switches connected in series and/or in parallel.

15. Power amplifier according to claim 14, characterised thereby, that the semiconductor switches are MOS field effect transistors (MOSFET) or static induction transistors (SIT) or static induction thyristors (SITh or cut-off thyristors (GTO) or cascade circuits or cascode circuits.

16. Power amplifier according to one of the claims 8 to 15, characterised thereby, that an additional low pass filter (FL, FC) is connected behind the amplifier modules (V1 to VN) connected in series at the output.

17. Power amplifier according to one of the claims 1 to 16, characterised by the use as modulation amplifier, in particular as modulation amplifier for amplitude-modulated high-power radio transmitters of the long, medium and short wave ranges with an anode-modulated radio-frequency output stage valve.

18. Power amplifier according to one of the claims 1 to 16, characterised by the use as high-voltage direct current supply, in particular for the current supply of magnets in particle accelerator installations.

## Revendications

1. Amplificateur de puissance pour amplifier un signal d'entrée analogique (NF), comprenant N modules d'amplificateur à commutation (V), montés en série côté sortie, et un filtre passe-bas côté sortie, dans lequel les interrupteurs (SCH1; SCH2) des modules d'amplificateur (V) sont commandés par des signaux d'un circuit de commande (ST), signaux qui sont tirés du signal d'entrée (NF), dans lequel, en tant qu'amplificateurs à commutation, des amplificateurs à commutation commutés côté secondaire sont prévus dans les modules d'amplificateur (V), et dans lequel deux amplificateurs à commutation, montés directement en série l'un derrière l'autre et constitués chacun d'une alimentation tension continue (UB1; UB2), d'un interrupteur (SCH1; SCH2) et d'une diode de roue libre (FD1; FD2), sont réunis chaque fois en un module d'amplificateur (V), de manière que les alimentations tension continue (UB1; UB2) et les diodes de roue libre (FD1, FD2) des deux amplificateurs à commutation soient chaque fois connectées en série, caractérisé en ce que les amplificateurs à commutation sont commandés par des séries d'impulsions modulées en durée d'impulsion, qui sont mutuellement déphasées, qu'un montage en série composé d'un interrupteur supplémentaire (SCH3; SCH4) et d'une résistance (R1; R2) est connecté chaque fois, dans le module d'amplificateur (V), en parallèle avec la diode de roue libre (FD1; FD2) entre les deux alimentations tension continue (UB1, UB2) montées en série et les deux diodes de roue libre (FD1, FD2) connectées en série, que ces deux interrupteurs supplémentaires (SCH3, SCH4) sont commutés chaque fois de façon complémentaire, c'est-à-dire en opposition (en push-pull) avec le premier interrupteur (SCH1; SCH2) correspondant, que le filtre passe-bas (FL1, FC1; FL2, FC2) est intégré totalement ou partiellement dans les différents modules d'amplificateur (V1-VN) et que les deux condensateurs de filtrage (FC1, FC2) d'un module d'amplificateur à commutation sont connectés en série entre eux.

2. Amplificateur de puissance selon la revendication 1, caractérisé en ce que le déphasage entre deux séries d'impulsions qui se succèdent directement dans le temps est chaque fois de 360°/N.

3. Amplificateur de puissance selon la revendication 1 ou 2, caractérisé en ce que le circuit de commande (ST) est relié aux différents amplificateurs à commutation (V1-VN) par des lignes de commande (ST1-STN) réalisées de préférence sous la forme de câbles à fibres optiques.

4. Amplificateur de puissance selon la revendication 3, caractérisé en ce que
- pour générer les différentes séries d'impulsions, des modulateurs d'impulsions en durée (PDM1-PDMN), à fonctionnement numérique ou analogique, sont prévus dans le circuit de commande (ST);
- chacun de ces modulateurs d'impulsions en durée (PDM1-PDMN) rest relié, côté sortie, par l'une des lignes de commande (ST1-STN), réalisées de préférence sous la forme de câbles à fibres optiques, à l'amplificateur à commutation (V1-VN) qui lui est coordonné et, côté entrée, par une première ligne de transmission (LK1-LKN), à un étage de pré-modulation (VM) qui est commun à tous les modulateurs (PDM1-PDMN); et
- chacun de ces modulateurs d'impulsions en durée (PDM1-PDMN) est relié par son entrée de référence et à travers une seconde ligne de transmission (K1-KN) à un étage d'oscillateur de référence (ROS) commun à tous les modulateurs (PDM1-PDMN) et reçoit de celui-ci un signal de référence pourvu du déphasage de la série d'impulsions à générer par lui.

5. Amplificateur de puissance selon la revendication 3 ou 4, caractérisé en ce qu'une partie du signal de sortie de l'amplificateur, signal qui est appliqué avant ou après le filtre passe-bas (FL, FC), est envoyée comme signal de contre-réaction (RS) au circuit de commande (ST) ou à l'étage de pré-modulation (VM) à travers un diviseur de tension (SPT).

6. Amplificateur de puissance selon une des revendications 1 à 5, caractérisé en ce que
- les amplificateurs à commutation (V1-VN) sont équipés de transformateurs secteur (d'alimentation à partir du secteur);
- ces transformateurs secteur sont réunis en un transformateur secteur (TR) possédant un enroulement primaire (2) et un nombre d'enroulements secondaires (41-4N) correspondant au nombre des modules d'amplificateur à commutation (V1-VN);
- en cas d'utilisation de transformateurs secteur comportant un blindage, les blindages sont également réunis en un blindage (3) commun relié à la masse; et
- en cas de prévision d'un transformateur secteur triphasé comportant un nombre triple d'enroulements primaires, les enroulements primaires sont connectés en triangle.

7. Amplificateur de puissance selon une des revendications 1 à 5, caractérisé en ce que
- les amplificateurs à commutation sont équipés de transformateurs secteur (d'alimentation à partir du secteur);
- ces transformateurs secteur sont réunis en deux transformateurs secteur comportant chacun un enroulement primaire et un nombre d'enroulements secondaires correspondant à la moitié du nombre des modules d'amplificateur à commutation;
- les deux transformateurs secteur présentent de préférence chacun un blindage relié à la masse; et
- en cas de prévision de transformateurs secteur triphasés comportant un nombre triple d'enroulements primaires, les enroulements primaires d'un transformateur sont connectés en triangle et les enroulements primaires de l'autre transformateur sont connectés en étoile.

8. Amplificateur de puissance selon une des revendications 1 à 7, caractérisé en ce que
- les transformateurs secteur des deux amplificateurs à commutation sont réunis en un transformateur secteur (TR) commun aux deux alimentations tension continue (UB1, UB2) et de préférence de type triphasé, avec des enroulements secondaires (4) connectés ensemble en un point neutre (P1) dans un montage en étoile;
- les points de connexion (P2, P5, P8) entre les alimentations tension continue (UB1, UB2) montées en série, les diodes de roue libre (FD1, FD2) montées en série et les condensateurs de filtrage (FC1, FC2) montés en série, sont reliés directement au point neutre (P1) par une ligne de liaison (VL) traversante; et
- les points terminaux (P3, P6, P9; P4, P7, P10) des trois montages en série constitués des alimentations tension continue (UB1, UB2), des diodes de roue libre (FD1, FD2) et des condensateurs de filtrage (FC1, FC2), sont chaque fois reliés entre eux par un montage en série supplémentaire formé d'un interrupteur (SCH1; SCH2) et d'une bobine de filtrage (FL1; FL2), et le montage en série des diodes de roue libre (FD1, FD2) est connecté par chacun de ses points terminaux (P6; P7) entre un interrupteur (SCH1; SCH2) et une bobine de filtrage (FL1; FL2).

9. Amplificateur de puissance selon la revendication 8, caractérisé en ce que
- les deux filtres passe-bas dans le module d'amplificateur (V) sont formés chacun de plusieurs étages de filtrage (FL1, FC1; FL3, FC3 ou FL2, FC2; FL4, FC4) montés l'un à la suite de l'autre;
- les différents étages de filtrage contiennent chacun une bobine de filtrage (FL1-FL4) et un condensateur de filtrage (FC1-FC4) monté à la suite de la bobine de filtrage correspondante;
- les bobines de filtrage (FL1, FL3 ou FL2, FL4) des différents étages de filtrage d'un filtre passe-bas sont chaque fois montées en série entre elles et les condensateurs de filtrage (FC1, FC3 ou FC2, FC4) des étages de filtrage d'un filtre passe-bas sont chaque fois montés en parallèle entre eux;
- les condensateurs de filtrage (FC1, FC2 ou FC3, FC4) d'étages de filtrage de même ordre (FL1, FC1; FL2, FC2 OU FL3, FC3; FL4, FC4) des deux filtres passe-bas sont chaque fois connectés en série et
- les points de connexion (P8, P8') entre deux condensateurs de filtrage (FC1, FC2 ou FC3, FC4) connectés chaque fois en série, sont reliés directement au point neutre (P1) par la ligne de liaison (VL) traversante.

10. Amplificateur selon la revendication 8 ou 9, caractérisé en ce que
- les deux alimentations tension continue (UB1, UB2), montées en série dans le module d'amplificateur (V), sont constituées par deux circuits redresseurs triphasés à montage en étoile (G1, G3, G5 ou G2, G4, G6) raccordés en parallèle, mais suivant des polarités contraires aux extrémités opposées au point neutre (P1) des enroulements secondaires (4) du transformateur secteur (TR), et générant, par rapport au point neutre (P1), deux tensions continues de polarités différentes, ainsi que par un élément de filtrage (SL1, SC1 ou SL2, SC2) prévu à la suite de chaque circuit redresseur et composé d'une inductance de filtrage (SL1 ou SL2) et d'un condensateur de filtrage (SC1 ou SC2); et
- les condensateurs de filtrage (SC1, SC2) des deux éléments de filtrage (SL1; SC1 ou SL2, SC2) sont connectés en série et leur point de connexion commun est le point de connexion (P2) des deux alimentations tension connue (UB1, UB2), lequel est relié directement au point neutre (P1) par la ligne de liaison (VL) traversante.

11. Amplificateur de puissance selon une des revendications 8 à 10, caractérisé en ce que chacun des deux points terminaux (P3; P4) du montage en série des alimentations tension continue (UB1, UB2) est relié à travers une diode d'écrêtage (KD1; KD2) à la sortie (A; B) qui lui est coordonnée du module d'amplificateur (V).

12. Amplificateur de puissance selon une des revendications 8 à 11, caractérisé en ce que des relais de protection de puissance (RE1-RE3) sont montés, côté secondaire, à la suite du transformateur secteur (TR).

13. Amplificateur de puissance selon une des revendications 8 à 12, caractérisé en ce que les différents modules d'amplificateur (V1-VN) sont de même structure et fournissent essentiellement des signaux de sortie identiques.

14. Amplificateur de puissance selon une des revendications 8 à 13, caractérisé en ce que les interrupteurs (SCH1-SCH4) dans les différents modules d'amplificateur (V) sont formés chaque fois d'un interrupteur à semi-conducteur ou de plusieurs interrupteurs à semi-conducteurs montés en série et/ou en parallèle.

15. Amplificateur de puissance selon la revendication 14, caractérisé en ce que les interrupteurs à semi-conducteurs sont des transistors à effet de champ MOS (MOSFET), des transistors à induction statique (SIT), des thyristors à induction statique (SITh) ou des thyristors de blocage (GTO), des montages en cascade ou des montages en cascode.

16. Amplificateur de puissance selon une des revendications 8 à 15, caractérisé en ce que les modules d'amplificateur (V₁-V_{N}), montés en série par leurs sorties, sont suivis d'un filtre passe-bas supplémentaire (FL, FC).

17. Amplificateur de puissance selon une des revendications 1 à 16, caractérisé par son application comme amplificateur de modulation pour des émetteurs, en particulier comme amplificateur de modulation pour des émetteurs radioélectriques haute puissance modulés en amplitude de la gamme des grandes, moyennes et courtes ondes, avec un tube d'étage final RF à modulation d'anode.

18. Amplificateur de puissance selon une des revendications 1 à 16, caractérisé par son application comme alimentation courant continu à haute tension, en particulier pour l'alimentation d'électroaimants dans les installations d'accélérateurs de particules.
